# EUROPEAN PATENT APPLICATION

(11) **EP 3 142 158 A1**
(43) Date of publication of application: **15.03.2017**
(21) Application number: 15185040.1
(22) Date of filing: 14.09.2015
(51) Int. Cl.: H01L 33/50, H01L 33/60

(54) **SOLID STATE LIGHTING UNIT AND MANUFACTURING METHOD FOR THE SAME**

(71) Applicant: Lumileds Holding B.V., 1118 BG Schiphol (NL)
(72) Inventor: The designation of the inventor has not yet been filed
(74) Representative: ter Heegde, Paul Gerard Michel

(57) **Abstract**

A solid state lighting unit comprises a substrate and a semiconductor light source mounted over the substrate. A reflective material is provided at exposed lateral edges of the semiconductor light emitting layer structure; and a light absorbing cover layer is provided over the reflective material, with an opening in the light absorbing cover layer around the upper light emitting surface. This arrangement provides improved optical contrast when using a reflective side-coating material. This avoids the need to use a highly absorbing side-coating material, and therefore avoids large optical losses.

## Description

### FIELD OF THE INVENTION

The present invention relates to a solid state lighting unit, for example for use in automotive applications.

### BACKGROUND OF THE INVENTION

Solid state lighting, in particular LED lighting, is rapidly becoming the lighting technology of choice in many application domains due to its energy efficiency and lifetime credentials, i.e. superior failure rates compared to incandescent light bulb-based solutions. This is further aided by improvements in the cost and appearance of solid state lighting devices, thus improving consumer acceptance of these devices.

One area in which LED lighting is increasingly being used is automotive lighting. Exterior automotive illumination requires a good control of the angular distribution of light in order to avoid glare. This is in contrast to general illumination where the focus is on maximum light output and less on angular distribution of the light.

For this purpose, it is known to use a side-coating material to prevent the output of light laterally from the sides of an LED unit.

An LED unit may for example comprise an LED package, having connections within the package between the semiconductor contacts of the LED and external connection terminals. These external connection terminals then connect to a printed circuit board. A side-coating material may be applied to the side of the LED package.

The desire to reduce cost has led to the use of Chip-on-Board (CoB) designs, in particular flip-chip CoB. This involves mounting a bare chip on a substrate, rather that first forming a package. When using bare chips on a substrate (typically a printed circuit board, PCB, or metal core PCB, MCPCB, also known as an Insulated Metal Substrate IMS) the application of a side-coating material needs to be implemented at the board level.

One cost-effective way to apply the side-coating material is by dispensing, such as single component dispensing. Due to the nature of the process, the side-coating material forms a meniscus at the sidewall of the LED. Depending on the surface tension between the side-coating material and LED, the shape of the meniscus and thus the thickness of the side-coating material at the top side of the LED can vary strongly. In some cases, depending on the properties of the side-coating material, the thickness is too thin which leads to leakage light and thus a bad optical contrast between the LED region and the side-coating region.

Placing a light blocking material at the edge of the LED also reduces the optical efficiency of the LED, as part of the light output is absorbed. Light output efficiency is improved if a reflective side-coating material is used, but this then results in worse optical contrast due to the non-perfect reflectivity of reflective side-coating materials.

### SUMMARY OF THE INVENTION

The present invention seeks to provide improved contrast in a solid state lighting unit when using a side-coating material.

According to an aspect, there is provided a solid state lighting unit, comprising:
a substrate;
a semiconductor light source mounted over the substrate having a semiconductor light emitting layer structure with an upper light emitting surface and an exposed lateral edge arrangement;
a reflective material provided at the exposed lateral edge arrangement of the semiconductor light emitting layer structure; and
a light absorbing cover layer over the reflective material, with an opening in the light absorbing cover layer around the upper light emitting surface.

This arrangement provides improved optical contrast when using a reflective side-coating material. The reflective material acts as a volume reflector rather than a light blocking structure. The cover layer provides the light blocking. This avoids the need to use a highly absorbing side-coating material against the edge of the light source, and therefore avoids large optical losses, but it also maintains the desired optical contrast.

The reflective material may for example be a white material. This increases the light output of the light source. Due to imperfect reflectivity, and a finite penetration depth of the LED light into the side-coating material, the side-coating material only achieves a limited contrast. The contrast is improved by the cover layer. The contrast is a particularly important factor in light sources for automotive lighting. The cover layer is for example around the top edge of the light emitting area. Hence, a combination of a highly reflective side-coating and an absorbing (i.e. black) top layer together enables a high luminous flux while simultaneously increasing contrast.

The edge arrangement typically comprises a set of four edges for a light source with a rectangular (or square) shape. However, other shapes are possible, for example including a circle in which case the edge arrangement may be a single curved edge.

The reflective material may comprise a one-component material with reflective properties. However, a two-component (or multi-component) solution/emulsion may be used where a polymer material is filled with particles of filler materials. The mechanical and optical properties can be tuned by the mixing ratio of both parts and the particle geometry including the size, size distribution and shape.

The reflective material for example has a reflectivity of at least 0.7 at a material thickness of 100µm for the range of wavelengths for which light is emitted by the light source and, for a design which includes a phosphor conversion layer, for the range of wavelengths for which phosphor converted light is output. Thus, a majority of the radiant intensity in the wavelength range of interest is reflected.

The cover layer may also comprise a one-component material with highly absorbing material properties for the range of wavelengths. Alternatively, a two-component (or multi-component) solution/emulsion may again be used based on a polymer material filled with particles of one or more filler materials.

The cover layer for example has an absorptance of at least 0.7 for a material thickness of 100µm for the range of wavelengths for which light is emitted by the light source and, for a design which includes a phosphor conversion layer, for the range of wavelengths for which phosphor converted light is output.

The cover layer for example forms a bridge between the top of the semiconductor light source and the substrate, which encloses the reflective material. In this way, light is prevented from escaping from the surface of the reflective side-coating as much as possible.

Since the undesired light extraction out of the reflective side-coating is the highest close to the LED, it is not necessarily needed to form a bridge of absorbing layer between semiconductor light source and substrate, but most important is to have the absorbing layer on top of the reflective layer close to the outer edge of the semiconductor light source.

Thus, the cover layer may instead form a cover around the top of the semiconductor light source which does not extend fully down to the substrate. It may for example extend only tens or hundreds of micrometers outwardly from the cover layer opening.

The semiconductor light source for example comprises an LED or an array of LEDs. Other semiconductor light emitting devices may however be used.

As mentioned above, a phosphor layer may be provided over the semiconductor light emitting layer structure. This is used for wavelength conversion of the light output from the light source.

The substrate may comprise a printed circuit board, and the semiconductor light source is soldered to the printed circuit board. However, other substrates may be used, such as lead frames or ceramic supports for creating semiconductor lighting packages which are then for attachment to a PCB, thus without the need to apply the reflective material and cover layer at board level.

The invention also provides a method of manufacturing a solid state lighting unit, comprising:
mounting a semiconductor light source over a substrate, the semiconductor light source having a semiconductor light emitting layer structure with an upper light emitting surface and an exposed lateral edge arrangement; and
providing a reflective material at the exposed lateral edge arrangement of the semiconductor light emitting layer structure and a light absorbing cover layer over the reflective material, with an opening in the light absorbing cover layer around the upper light emitting surface.

The reflective material may be dispensed, then the material of the light absorbing cover layer may be dispensed, and both may be cured. This provides a sequential deposition followed by shared curing.

Alternatively, the reflective material may be dispensed, followed by curing or partially curing, then the material of the light absorbing cover layer may be dispensed and then cured. The intermediate curing or partial curing provides a firmer base on which the cover layer may be deposited.

The reflective material may comprise a one-component material with reflective properties. However, a two-component solution/emulsion may be used based on a polymer material filled with particles of one or more filler materials. The cover layer may also comprise a one-component material with highly absorbing material properties for the range of wavelengths. Alternatively, a two-component solution/emulsion may again be used based on a polymer material filled with particles of one or more filler materials.

The method may comprise providing a phosphor layer over the semiconductor light emitting layer structure.

The reflective layer and/or the cover layer may be provided by one of a number of different processes, such as:
dispending with a pressure-time valve; or
dispending with an auger valve; or
jetting; or
spraying; or
printing; or
molding.

Alternatively, the reflective layer and the cover layer may be formed into a discrete frame component which is then provided over the semiconductor light source.

### BRIEF DESCRIPTION OF THE DRAWINGS

Embodiments of the invention are described in more detail and by way of nonlimiting examples with reference to the accompanying drawings, wherein:
- Figure 1: shows a lighting unit;
- Figure 2: shows a one dimensional array of lighting units sharing a side-cover arrangement; and
- Figure 3: shows a two dimensional array of lighting units sharing a side-cover arrangement.

### DETAILED DESCRIPTION OF THE EMBODIMENTS

It should be understood that the Figures are merely schematic and are not drawn to scale. It should also be understood that the same reference numerals are used throughout the Figures to indicate the same or similar parts.

The invention provides a solid state lighting unit, comprising a substrate and a semiconductor light source mounted over the substrate. In this context, the term "substrate" is used to refer generally to a carrier layer. A reflective material is provided at exposed lateral edges of the semiconductor light emitting layer structure. A light absorbing cover layer is provided over the reflective material, with an opening in the light absorbing cover layer around the upper light emitting surface. This arrangement provides improved optical contrast compared to using only a reflective side-coating material. A good optical contrast would also be achieved by using only a highly absorbing side-coating material, but this would lead to large optical losses.

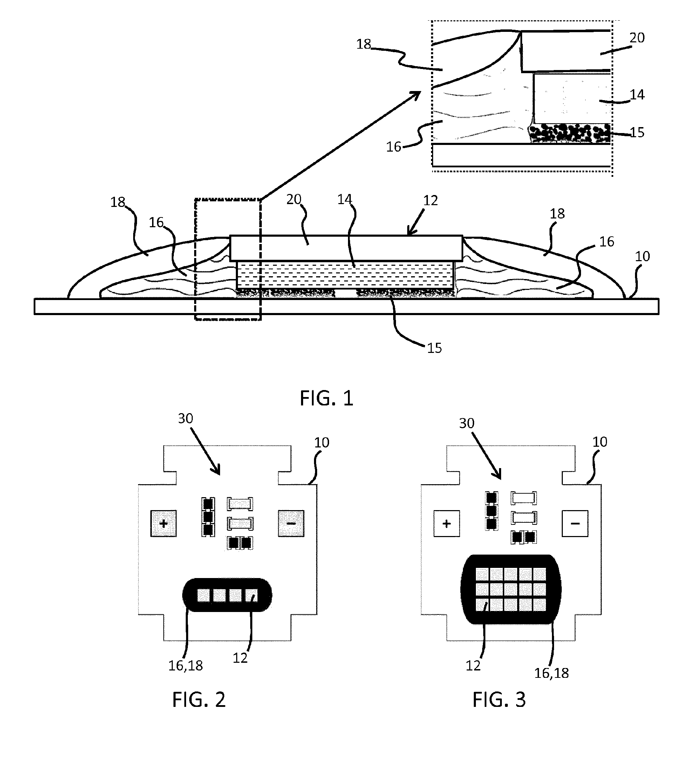

Figure 1 shows a lighting unit. It comprises a substrate 10 for example in the form of a printed circuit board on which a semiconductor light source 12 is mounted. The light source is most typically an LED or an array of LEDs. The light source has a semiconductor light emitting layer structure 14 with an upper light emitting surface. It is mounted to the substrate 10 by solder pads 15. The light source is typically a square or rectangle, and it has exposed edges.

A reflective material 16 is provided at the exposed edges to return laterally emitted light to the light source for re-absorption and re-emission, thereby increasing the forward emission efficiency.

A light absorbing cover layer 18 is provided over the reflective material 14. The cover layer 18 has an opening around the upper light emitting surface.

In the example shown, the cover layer 18 butts against the side of light source at the top. It may instead overlap the top of the light source. The opening provides a high contrast boundary between a light emission area and a light absorbing area.

The light emitting surface is in the example shown covered by a phosphor layer 20.

Typical height dimensions (z-direction) for the semiconductor light emitting layer structure 14 can range from 5µm to 250µm. The phosphor converter height for example may range from 5µm to 200µm.

The LED chip in-plane dimensions (x- and y-directions) may for example range from 300µm to 2000µm.

The LED arrays can range from 1 x 1 LED chip to arrays containing several hundred chips (for example up to 30 x 30 or 20 x 50 or 10 x 100 LED chips).

This arrangement provides improved optical contrast when using a reflective side-coating material. The structure incorporates two different side-coating materials each serving a specific purpose. Due to limitations in reflectivity of commonly used side-coating materials, in particular a certain penetration depth of photons into the material, and thereby the possibility of photons exiting the top surface of the reflective side-coating material, only a limited contrast can be reached by solely using a reflective material. The combination of a highly reflective material and an absorbing cover layer facilitates a high luminous flux while simultaneously increasing contrast.

The reflective material 16 may for example be a white material. The reflective material may comprise a one-component material with reflective properties. However, typically, a two component solution/emulsion is used where a polymer material (e.g. silicone, epoxy, resin or other polymers) is filled with particles of filler materials (e.g. TiO2 titanium dioxide, SiO2, SiN, Al2O3, AlN, BaSO4 Barium Sulfate, ZnS zinc sulfide, MgF2 magnesium fluoride or others). One or more types of filler material particles may be used. The mechanical and optical properties can be tuned based on the mixing ratio of the two parts and the particle geometry, including the size, size distribution and shape.

The reflective material for example has a reflectivity of at least 0.7 at a material thickness of 100µm for the range of wavelengths for which light is emitted by the light source, either directly or after wavelength conversion, for example by a phosphor conversion layer. In other words, at least 70% of the radiant intensity in the wavelength range of interest is reflected.

The cover material 18 may for example be a black material. The cover layer may comprise a single component with highly absorbing material properties for the range of wavelengths of interest, as explained above. Alternatively, a two-component solution/emulsion may again be used - where a polymer material (e.g. silicone, epoxy, resin or others) is filled with particles of filler materials (e.g. graphite/carbon/soot, metal particles/flakes, polymers like liquid crystal polymer (LCP), vulcanized macro-molecules or others.

The cover layer for example has an absorptance of at least 0.7 for a material thickness of 100µm for the range of wavelengths for which light is emitted by the light source. In other words, at least 70% of the radiant intensity in the wavelength range of interest is absorbed.

The cover layer for example forms a bridge between the top of the semiconductor light source 12 and the substrate 10 which encloses the reflective material. In this way, light is prevented from escaping from the lateral edges of the light source as much as possible. However, since the undesired light extraction out of the reflective side-coating is the highest close to the LED, it is not necessarily needed to form a bridge of absorbing layer between the semiconductor light source and substrate, but most important is to have the absorbing layer on top of the reflective layer close to the outer edge of the semiconductor light source. For example, the cover layer may have a width of tens or hundreds of micrometers.

Figure 2 shows a one dimensional 1 x 4 array (i.e., a line) of lighting units 12 sharing a side-cover arrangement 16,18. It also shows other components 30 mounted on the printed circuit board. Figure 3 shows a two dimensional 3 x 5 array of lighting units 12 sharing a side-cover arrangement 16,18.

Especially for automotive matrix beam applications without primary optics, where the image of the chip array is directly projected onto the road, a high optical contrast is beneficial in order to avoid glare. The classic automotive low beam (also known as dipped beam) application also requires a good optical contrast in order to illuminate the lane in front of the car very brightly (hot spot) and other defined regions (e.g. opposing lane) which are quite close to each other as little as possible in order to avoid glare.

An example of a manufacturing process will now be given, based on a Chip-on-Board (CoB) dispense process. A dispense or jetting system is used to apply the two different side-coating materials.

After soldering of the LED chip or chips (including the phosphor layer when one is needed) on the carrier 10, the white reflective material 16 is dispensed around the LED(s). By selecting a material with suitable flow characteristics, the material will automatically spread on the carrier, covering the area around the LED sidewalls as well as the phosphor layer and the gaps between the LED chips. As a consequence of the interaction between the reflective material and the surface, a concave meniscus of white material is formed around the sidewalls.

As an alternative option, it is also possible to use a so-called "dam and fill" approach, where first a closed line of highly viscous material is placed around the LED/LED array at a certain distance - this material forms a "dam". Subsequently, the less viscous reflective side-coating material is applied inside of the dam to fill the volume around and between the LEDs.

In the next step, the black cover layer 18 is applied on top of the white material 16, thereby fully covering the white reflective layer.

The materials are cured after deposition. There are two basic process options as shown in the table below:

| **Approach** | **Step 1** | **Step 2** | **Step 3** | **Step 4** |
|---|---|---|---|---|
| (A) | Dispensing of white material | Dispensing of black material | Final curing | |
| (B) | Dispensing of white material | Intermediate curing | Dispensing of black material | Final curing |

In approach (A) the two materials are dispensed in succession followed by one curing step. This approach is used if no significant intermixing of the materials is expected. In order to save time, a dual head dispensing system may be used. Thus, both materials can be applied within the same process step leading to a gain in overall processing time and dimension of the industrial line.

In approach (B) an intermediate curing step is implemented to harden the white bottom layer before dispensing the black material on top, thereby preventing intermixing effects.

The process can be adapted to a variety of different embodiments.

For example, instead of mounting LED chips onto a PCB carrier, the LED package may already include a substrate, which is then for mounting on a printed circuit board (i.e. a further substrate). In this case, the LED chip is placed inside a lead-frame housing, or on a ceramic tile, or onto a transfer tape/dicing tape, and these function as the carrier. The side-coating process is then applied at the LED package level rather than at the PCB level. The lighting units are then singularized and can be used as traditionally packaged LEDs.

The invention may thus be applied to wafer level packaging (WLP) and chip scale packaging (CSP) solutions.

There are various different options for the deposition of each of the two different side-coating materials. The same process may be used for the different materials (at the same time or at sequential times as explained above) or else different processes may be used for the two layers. Examples of possible process are:
1. Dispensing using a pressure time-valve.
2. Dispensing using an auger valve.
3. Jetting using a "drop-on-demand" like setup (e.g. piezo-jetting, bubble jet, ink-jet, tappet-based).
4. Spray coating.
5. Screen printing / stencil printing.
6. Molding process.
7. Placing of a pre-manufactured two-colored side-coating frame over the LED chip.

The main example above is based on a chip-on-board structure. However, as will be clear from the discussion above, the concept of providing a separate reflective material layer and light absorbing cover layer may be applied to other types of LED package mounted on a carrier, such as classical LED packages.

The main example above is also based on a flip-chip LED with two bottom contacts (anode and cathode). The invention can also be applied to vertically injected thin film (VTF) LEDs which comprise a continuous contact at the bottom and a wire bond making contact to the top side of the chip.

Other chip architectures are also possible such as lateral die LEDs which for example make use of two wirebonds for contact to a lead frame.

The invention may thus be applied to a variety of LED package technologies as will be understood by those skilled in the art.

The invention can be used in many different applications, either as discrete lighting packages or as part of a PCB process. There are many automotive and non-automotive applications.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. The word "comprising" does not exclude the presence of elements or steps other than those listed in a claim. The word "a" or "an" preceding an element does not exclude the presence of a plurality of such elements. The invention can be implemented by means of hardware comprising several distinct elements. In the device claim enumerating several means, several of these means can be embodied by one and the same item of hardware. The mere fact that certain measures are recited in mutually different dependent claims does not indicate that a combination of these measures cannot be used to advantage.

## Claims

1. A solid state lighting unit, comprising:
a substrate (10);
a semiconductor light source (12) mounted over the substrate having a semiconductor light emitting layer structure (14) with an upper light emitting surface and an exposed lateral edge arrangement;
a reflective material (16) provided at the exposed lateral edge arrangement of the semiconductor light emitting layer structure; and
a light absorbing cover layer (18) over the reflective material, with an opening in the light absorbing cover layer around the upper light emitting surface.

2. A lighting unit as claimed in claim 1, wherein the reflective material (16) comprises a single-component material or a multi-component material comprising a polymer material and reflecting particles of a filler material.

3. A lighting unit as claimed in claim 1 or 2, wherein the cover layer (18) comprises a single-component material or a multi-component material comprising a polymer material and absorbing particles of a filler material.

4. A lighting unit as claimed in any preceding claim, wherein the cover layer (18) forms a bridge between the top of the semiconductor light source (12) and the substrate (10), which bridge encloses the reflective material.

5. A lighting unit as claimed in any one of claims 1 to 3, wherein the cover layer (18) forms a cover around the top of the semiconductor light source (12) which does not extend fully down to the substrate.

6. A lighting unit as claimed in any preceding claim, wherein the semiconductor light source (12) comprises an LED or an array of LEDs.

7. A lighting unit as claimed in any preceding claim, further comprising a phosphor layer (20) over the semiconductor light emitting layer structure.

8. A lighting unit as claimed in any preceding claim, wherein the substrate (10) comprises a printed circuit board, and the semiconductor light source is soldered to the printed circuit board.

9. A method of manufacturing a solid state lighting unit, comprising:
mounting a semiconductor light source (12) over a substrate (10), the semiconductor light source having a semiconductor light emitting layer structure (14) with an upper light emitting surface and an exposed lateral edge arrangement; and
providing a reflective material (16) at the exposed lateral edge arrangement of the semiconductor light emitting layer structure and a light absorbing cover layer (18) over the reflective material, with an opening in the light absorbing cover layer around the upper light emitting surface.

10. A method as claimed in claim 9, comprising:
dispensing the reflective material (16), dispensing the material of the light absorbing cover layer (18), and curing both the reflective material and the material of the light absorbing cover layer; or
dispensing the reflective material (16), curing or partially curing the reflective material, dispensing the material of the light absorbing cover layer (18), and curing the material of the light absorbing cover layer.

11. A method as claimed in claim 9 or 10, wherein the reflective material (16) comprises a single-component material or a multi-component material comprising a polymer material and reflecting particles of a filler material.

12. A method as claimed in any one of claims 9 to 11, wherein the cover layer (18) comprises a single-component material or a multi-component material comprising a polymer material and absorbing particles of a filler material.

13. A method as claimed in any one of claims 9 to 12, comprising providing a phosphor layer (20) over the semiconductor light emitting layer structure.

14. A method as claimed in any one of claims 9 to 13, wherein the reflective layer and/or the cover layer are provided by:
dispending with a pressure-time valve; or
dispending with an auger valve; or
jetting; or
spraying; or
printing; or
molding.

15. A method as claimed in any one of claims 9 to 13, wherein the reflective layer and the cover layer are formed into a discrete frame component which is then provided over the semiconductor light source.
